# EUROPEAN PATENT APPLICATION

(11) **EP 4 554 349 A1**
(43) Date of publication of application: **14.05.2025**
(21) Application number: 24772549.2
(22) Date of filing: 26.08.2024
(51) Int. Cl.: H05K 7/20, H04M 1/02

(54) **THERMAL DIFFUSION MEMBER AND ELECTRONIC DEVICE COMPRISING SAME**

(30) Priority: 27.09.2023 KR 20230131258; 23.11.2023 KR 20230164271
(71) Applicant: Samsung Electronics Co., Ltd., Suwon-si, Gyeonggi-do 16677 (KR)
(72) Inventor: JIN, Gyeongmin, Suwon-si, Gyeonggi-do 16677 (KR); PARK, Kookjin, Suwon-si, Gyeonggi-do 16677 (KR); PARK, Jongkil, Suwon-si, Gyeonggi-do 16677 (KR); SUNG, Jungoh, Suwon-si, Gyeonggi-do 16677 (KR); LIM, Jonghyun, Suwon-si, Gyeonggi-do 16677 (KR)
(74) Representative: Nederlandsch Octrooibureau
(86) International application number: PCT/KR2024/012669
(87) International publication number: WO 2025/071034

(57) **Abstract**

An electronic device disclosed in the disclosure may include a housing, a first electronic component disposed in a first area of an interior of the housing, a second electronic component disposed in a second area being different from the first area of the interior of the housing, and a heat diffusion member disposed in a heat dissipation area formed from the first area to the second area, and including a first part corresponding to the first area, a second part corresponding to the second area, and a connecting part connecting the first part and the second part, and the heat diffusion member includes at least one recess. In addition, various embodiments identified through the specification are possible.

## Description

### [Technical Field]

Embodiments disclosed in the disclosure relate to a member that may lower a temperature of an interior component of an electronic device, and an electronic device including the same.

### [Background Art]

While electronic devices are becoming increasingly smaller, functions thereof are becoming more diverse. Electrical elements or electrical components that are built in electronic devices may be disposed such that distances from surrounding structures are gradually narrowed or concentrated as electronic devices are miniaturized and slimmed, and may generate high temperatures due to performance of various functions. High temperature heat that is generated in an interior of an electronic device may cause a malfunction of the electronic device, damage electrical elements or components of the interior of the electronic device, and cause discomfort to the user. Accordingly, a heat dissipation structure that may effectively diffuse the heat generated from interior electrical elements or electrical components to the surroundings may be applied to electronic devices.

### [Disclosure]

### [Technical Solution]

An electronic device disclosed in the disclosure may include a housing, a first electronic component disposed in a first area of an interior of the housing, a second electronic component disposed in a second area being different from the first area of the interior of the housing, and a heat diffusion member disposed in a heat dissipation area formed from the first area to the second area, and including a first part corresponding to the first area, a second part corresponding to the second area, and a connecting part connecting the first part and the second part, and the heat diffusion member includes at least one recess.

The heat diffusion member may include a first part, a second part, to which heat is diffused from the first part, a connecting part connecting the first part and the second part, and a first recess extending from at least a portion of the first part to at least a portion of the second part via the connecting part.

### [Description of Drawings]

FIG. 1 is a view illustrating a configuration of an electronic device according to an embodiment.
FIG. 2 is a view illustrating a configuration of an electronic device according to an embodiment.
FIGS. 3A to 3D are views illustrating a structure of a heat diffusion member of an electronic device according to various embodiments.
FIG. 4 is a view illustrating a change in strength of a heat diffusion member of an electronic device according to an embodiment.
FIG. 5 illustrates results of simulation of a damage degree due to a drop impact of a heat diffusion member of an electronic device according to an embodiment.
FIG. 6 is a view illustrating a flange structure of a heat diffusion member according to various embodiments.
FIG. 7 is a view illustrating a structure of a heat diffusion member according to an embodiment.
FIG. 8 is a view illustrating a heat diffusion member that is disposed in an electronic device, according to an embodiment.
FIG. 9 illustrates an electronic device in a network environment according to various embodiments.

In relation to a description of the drawings, identical or similar reference numerals may be used for identical or similar components.

### [Mode for Invention]

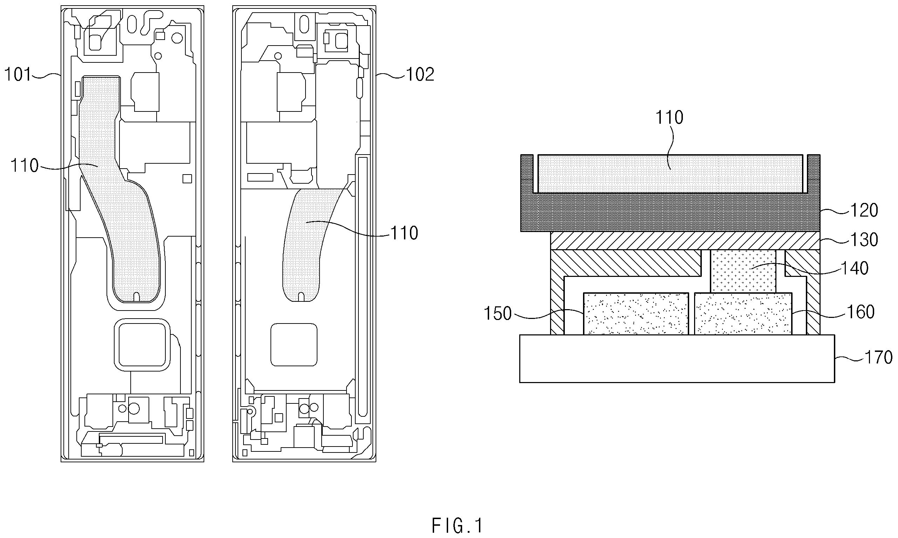

FIG. 1 is a view illustrating a configuration of an electronic device according to an embodiment. For example, a left drawing of FIG. 1 illustrates an interior structure of an electronic device as seen from a display direction of an electronic device, a central drawing of FIG. 1 illustrates an interior structure of the electronic device as seen from a rear side (an opposite surface of a display) of the electronic device, and a right drawing of FIG. 1 illustrates cross section A-A'.

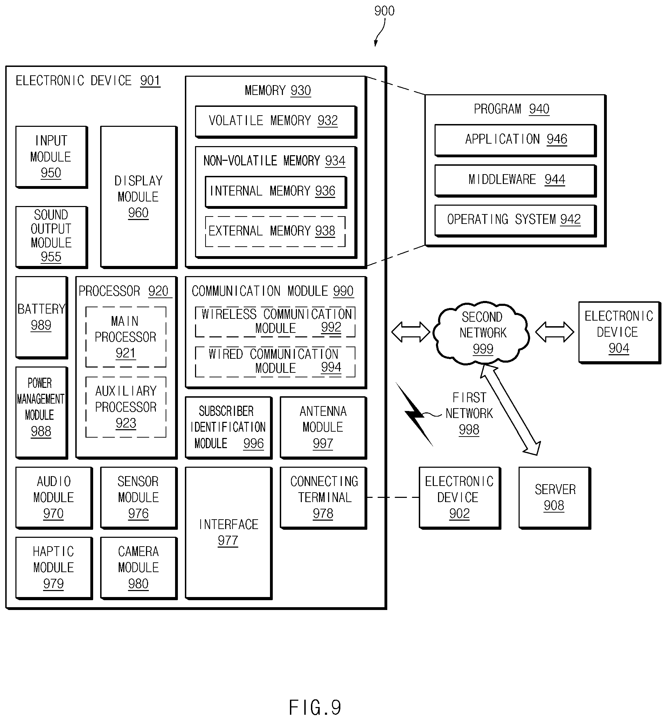

According to an embodiment, an electronic device 100 (e.g., an electronic device 901 of FIG. 9) may include a heat diffusion member 110 in the interior of a housing. For example, the housing may include a support structure 120. For example, the support structure 120 may define at least a portion of a side housing of the electronic device 100. The heat diffusion member **110** may be disposed in an interior space of the support structure 120.

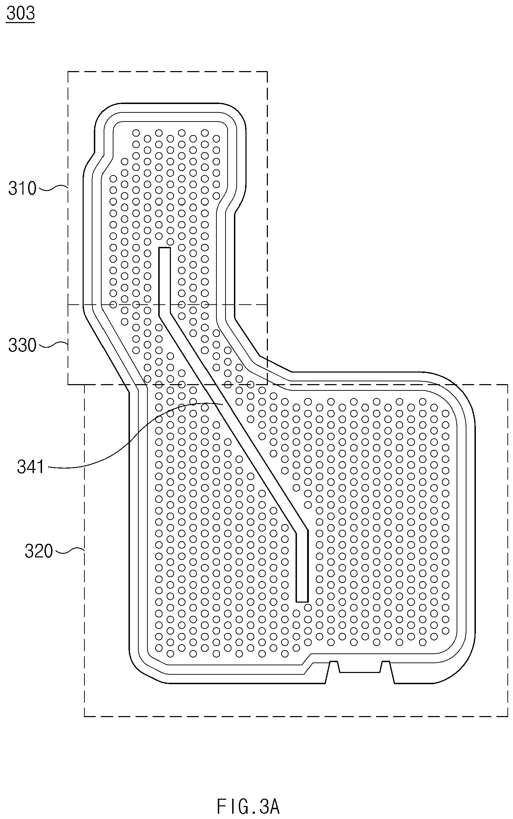

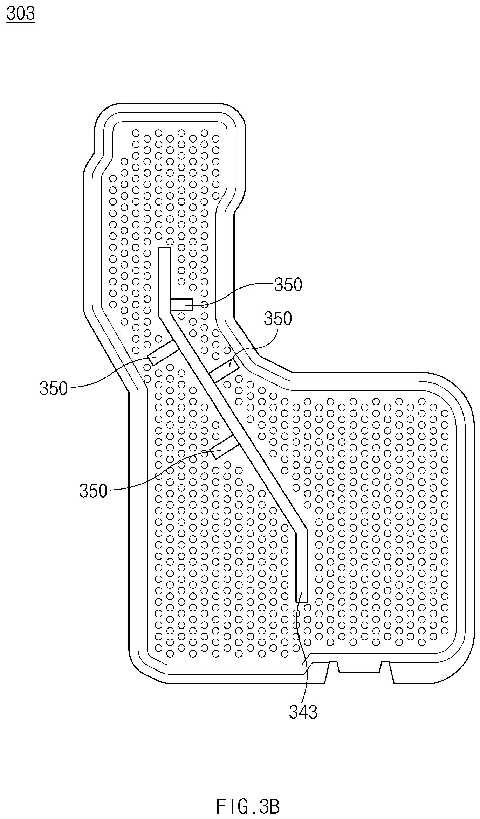

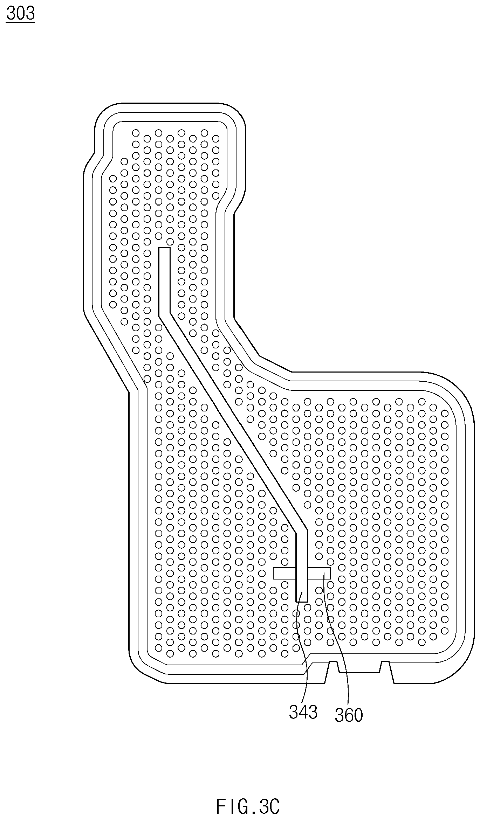

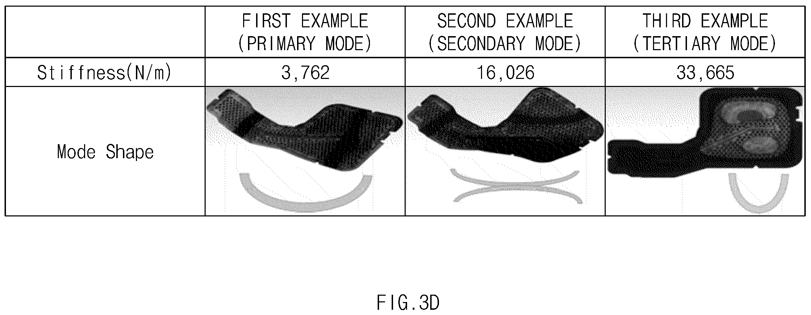

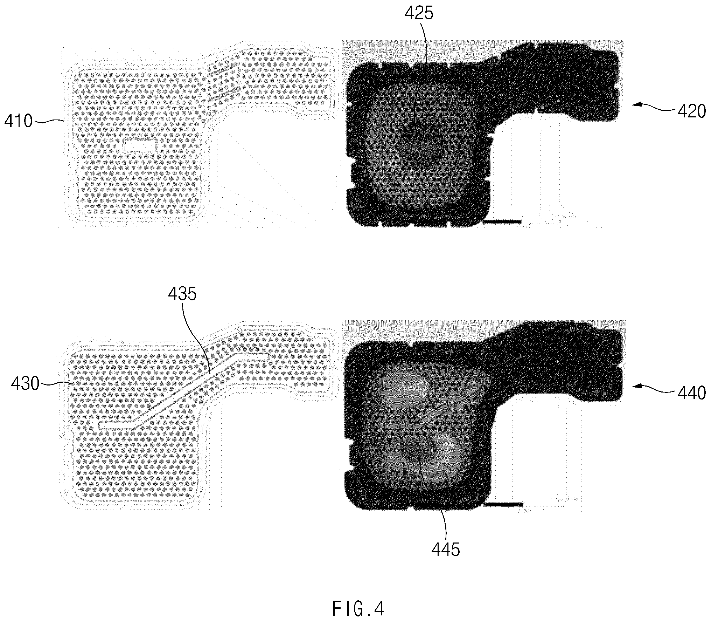

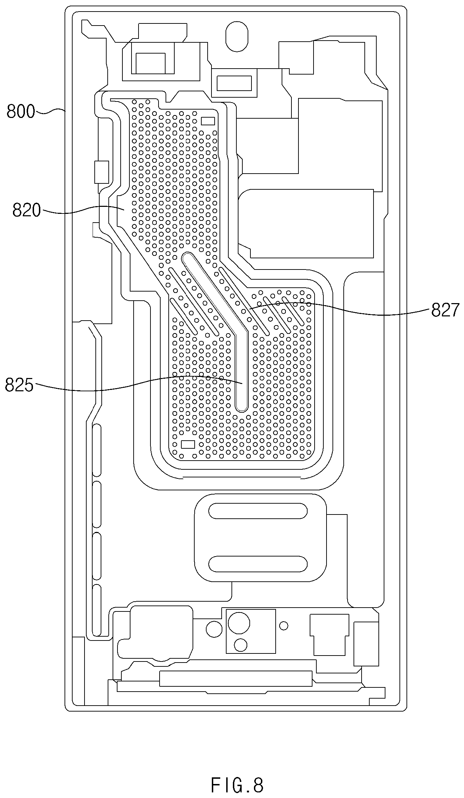

According to an embodiment, the electronic device 100 may include a heat diffusion member 110 (e.g., heat diffusion members 301, 303, and 305 of FIG. 3, a heat diffusion member 430 of FIG. 4, or a heat diffusion member 820 of FIG. 8), a support structure 120, a shield member 130, a heat transfer member 140, a memory 150, a processor 160, and/or a board (e.g., a circuit board) 170, in an interior of the housing.

According to an embodiment, the heat diffusion member **110** may diffuse heat that is generated in a first area (e.g., a first component (e.g., a processor 160)) of the interior of the electronic device 100 to a second area that is different from the first area of the interior of the electronic device 100. For example, the heat diffusion member 110 may lower a temperature of the interior (e.g., a first component) of the electronic device by diffusing heat that is generated from the first component that generates a relatively high temperature heat in the interior of the electronic device 100 to other sites. For example, the heat diffusion member 110 may include a vapor chamber. For example, referring to FIG. 1, the heat diffusion member 110 may have a substantially uniform width and be disposed along one direction (e.g., a longitudinal direction or a transverse direction) of the electronic device. For example, the heat diffusion member 110 may diffuse the heat that is generated from a component disposed in the first area along a lengthwise direction. According to an embodiment, the heat diffusion member 110 may be fixed to the support structure 120 through an adhesive tape, or may be fixed to the support structure 120 through laser welding.

According to an embodiment, the support structure 120 (e.g., a metal front structure) may fix the heat diffusion member 110. According to an embodiment, the support structure 120 may be formed of a metallic material. According to an embodiment, the support structure 120 may be disposed on a lower side of the heat diffusion member 110 to support the heat diffusion member 110.

According to an embodiment, the shield member 130 may decrease or shield electromagnetic interferences that occur in the interior of the electronic device 100. According to an embodiment, the shield member 130 may be formed of a metal or nanofiber (e.g., nano TIM) material. According to an embodiment, the shield member 130 may include a conductive shield film. According to an embodiment, the shield member 130 may be disposed on a lower side of the support structure 120.

According to an embodiment, the heat transfer member 140 (e.g., a gel TIM member) may transfer the heat from the interior (e.g., a component of the interior of the electronic device) of the electronic device to the heat diffusion member 110. According to an embodiment, the heat transfer member 140 may be disposed on a lower side of the shield member 130. For example, the heat transfer member 140 may be disposed between the first component (e.g., the processor 160) that serves as a heat source, and the heat diffusion member 110.

According to an embodiment, the memory 150 and the processor 160 may be disposed on the board 170. According to an embodiment, the memory 150 may include a universal flash storage (UFS). According to an embodiment, the memory 150 may store data that are used in the electronic device 100. According to an embodiment, the processor 160 may control an overall operation of the electronic device. For example, the processor 160 may be a heat source that emits heat at a relatively higher temperature than those of the other components in the interior of the electronic device 100.

According to an embodiment, the electronic device may include a battery (not illustrated). For example, at least a portion of the heat diffusion member 110 may be disposed to overlap the battery. For example, the heat diffusion member 110 may diffuse the heat generated from the first component (e.g., processor 160) toward the battery. For example, the heat diffusion member 110 may prevent a malfunction and a damage to the components in the interior of the electronic device 100 due to high temperature, by diffusing the heat emitted from the processor 160 that emits relatively high temperature heat, toward the relatively low temperature battery to lower the temperature of the processor 160.

According to an embodiment, disposition of the components and the interior of the electronic device in FIG. 1 is not limited to the illustration of FIG. 1.

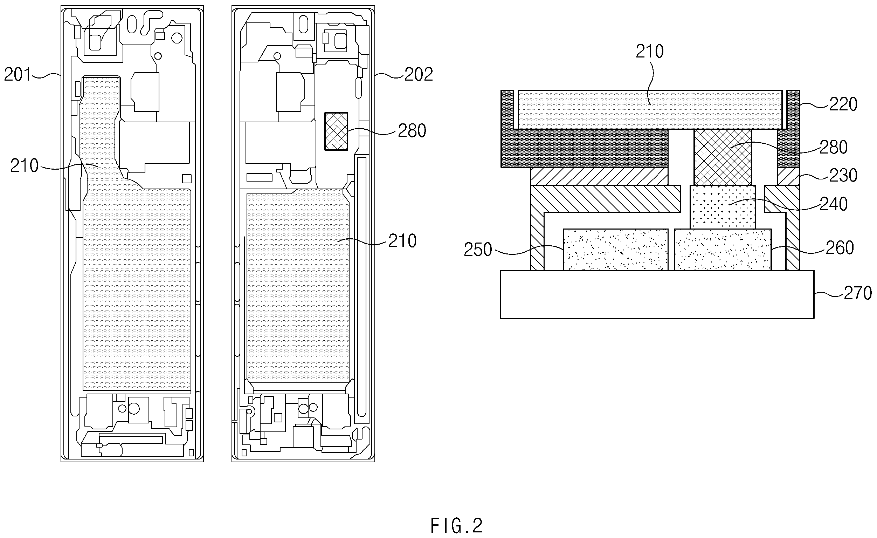

FIG. 2 is a view illustrating a configuration of the electronic device according to an embodiment. Hereinafter, a repeated description of FIG. 1 will be omitted or briefly described. According to an embodiment, disposition of the components and the interior of the electronic device in FIG. 2 is not limited to the illustration of FIG. 2. For example, a left drawing of FIG. 2 illustrates the structure of the interior of the electronic device as seen from the display direction of the electronic device, a central drawing of FIG. 2 illustrates the structure of the interior of the electronic device as seen from a rear side (an opposite side of the display) of the electronic device, and a right drawing of FIG. 2 illustrates cross section B-B'.

According to an embodiment, an electronic device 200 (e.g., the electronic device 901 of FIG. 9) may include a heat diffusion member 210 (e.g., the heat diffusion members 301, 303, and 305 of FIG. 3, the heat diffusion member 430 of FIG. 4, or the heat diffusion member 820 of FIG. 8) in the interior of the housing, a support structure 220, a shield member 230, a heat transfer member 240, an additional heat transfer member 280, a memory 250, a processor 260, and/or a board 270.

As compared to FIG. 1, the electronic device 200 may further include the additional heat transfer member 280. According to an embodiment, the support structure 220 or the shield member 230 may include some openings. In one embodiment, the additional heat transfer member 280 may be disposed between the processor 260 and the heat diffusion member 210 so that the heat emitted from the processor 260 may be transferred directly to the heat diffusion member 210. For example, the additional heat transfer member 280 may include a member (e.g., a metal block or a copper block) that is formed of a metallic material. The additional heat transfer member 280 may contact the heat diffusion member 210 and the heat transfer member 240, and the heat transfer member 240 may contact the processor 260. The heat generated in the processor 260 may be transferred to the heat diffusion member 210 through the heat transfer member 240 and the additional heat transfer member 280. For example, the heat generated in the processor 260 may be more easily transferred to the heat diffusion member 210 by the additional heat transfer member 280.

According to an embodiment, the heat diffusion member 210 may not be formed with the same width but may include areas with different widths. For example, the heat diffusion member 210 is formed to have a narrower width in an area corresponding to a component (e.g., the processor 260) that emits relatively high temperature heat in the interior of the electronic device 200, and may be formed to have a wider width in an area (e.g., an area that overlaps the battery), in which the heat is diffused. According to an embodiment, when the heat diffusion member 210 has a wider width (a larger area), a heat diffusion performance may increase and thus, it may be more efficient in lowering the temperature of the components of the interior of the electronic device 200. For example, when the heat diffusion member 210 has a wider width (a larger area), a strength of the heat diffusion member 210 may be weakened and thus damage, such as deformation or welding separation, may occur when an external impact is applied. Hereinafter, a structure of the heat diffusion member 210, which may strengthen a resistant force against an external impact, will be described in more detail in FIG. 3A and below.

FIGS. 3A to 3D are views illustrating the structure of the heat diffusion member of the electronic device according to various embodiments. According to an embodiment, the electronic device (not illustrated) (e.g., the electronic device 901 in FIG. 9) may include heat diffusion members 301, 303, and 305 (e.g., the heat diffusion member 110 of FIG. 1, the heat diffusion member 210 of FIG. 2, the heat diffusion member 430 of FIG. 4, or the heat diffusion member 820 of FIG. 8).

According to an embodiment, referring to FIG. 3A, a heat diffusion member 301 includes a first part 310, a second part 320, and a connecting member 330 that connects the first part 310 and the second part 320. According to an embodiment, the first part 310 may be located in a first electronic component (e.g., the processor) that is a heat emission source that emits relatively high temperature heat in the interior of the electronic device, and the second part 320 may be located in a second electronic component (e.g., the battery) that is disposed to be spaced apart from the heat emission source. According to an embodiment, a size (e.g., an area) of the first part 310 may be smaller than a size of the second part 320. For example, by increasing a size of the first part 310 or the second part 320, a heat diffusion performance (e.g., a heat dissipation performance) of the heat diffusion member 301 may be increased. For example, the first part 310 may be disposed in a position corresponding to the first area, in which the first electronic component (e.g., the processor) of the electronic device is disposed, and the second part 320 may be disposed in a position corresponding to the second area, in which the second electronic component (e.g., the battery) is disposed.

According to an embodiment, the heat diffusion member 301 may include at least one recess (and/or a slot). For example, the heat diffusion member 301 may include a first recess 341 that extends from at least a portion of the first part 310 through a connecting part 330 to at least a portion of the second part 320. For example, the first recess 341 may be formed along a long lengthwise direction (e.g., a long axis direction) of the heat diffusion member 301. For example, the heat diffusion member 301 may be vulnerable to folding deformation (for example, a vertically folded state when a longitudinal direction of the heat diffusion member 301 has a longer length than in the transverse direction) in the long lengthwise direction, the first recess 341 may decrease or prevent folding deformation of the heat diffusion member 301 in the long axis direction by increasing a bending strength in the long lengthwise direction. For example, the first recess 341 may be formed along a center line of the heat diffusion member 301 that extends from at least a portion of the first part 310 to at least a portion of the second part 320.

According to an embodiment, referring to FIG. 3B. a repeated description of FIG. 3A will be omitted or briefly described hereinafter. According to an embodiment, a heat diffusion member 303 may include at least one recess 343 or 350 (and/or a slot). For example, the heat diffusion member 303 may include a first recess 343 that is formed in the long axis direction. For example, the heat diffusion member 303 may include at least one second recess 350 that is formed in a second direction that is different from the first direction that is expanded from the first part (e.g., the first part 310 in FIG. 3A) to the second part (e.g., the second part 320 in FIG. 3A), in the connecting part (e.g., the connecting part 330 of FIG. 3A) of the heat diffusion member 303. For example, the heat diffusion member 303 may include at least one second recess 350 in at least one of the first part, the second part, and/or the connecting part. According to an embodiment, the at least one second recess 350 may be connected to the first recess 343 at one point. According to an embodiment, the at least one second recess 350 may be formed to be substantially perpendicular to the first recess 343. For example, the second recess 350 may be formed substantially in a short lengthwise direction (e.g., a short axis direction) of the heat diffusion member 303. According to an embodiment, the at least one second recess 350 may be formed in at least one of the first part, the connecting part, and/or the second part. For example, the at least one second recess 350 may improve a torsional strength of the heat diffusion member 303.

According to an embodiment, referring to FIG. 3C, a repeated description of FIGS. 3A and 3B will be omitted or briefly described hereinafter. According to an embodiment, a heat diffusion member 305 may include at least one recess 345 or 350 (and/or a slot). For example, the heat diffusion member 305 may include a first recess 345 that is formed in the long axis direction. For example, the heat diffusion member 305 may include at least one third recess 360 that is formed to have a specified angle with the first recess 345 in the second part (e.g., the second part 320 in FIG. 3A). For example, the at least one third recess 360 may include a recess that intersects the first recess 345 at a substantially right angle. For example, the at least one third recess 360 may decrease a dome-shaped deformation area that may occur in the second part and/or decrease a dome-shaped deformation degree. For example, the first recess 345 and/or the third recess 360 may disperse the dome-shaped deformation that may occur throughout the second area into a plurality of small dome-shaped deformations. For example, the first recess 345 and/or the third recess 360 may disperse the amount of impact applied to the second area and decrease a degree, by which the second area is deformed.

Referring to FIG. 3D, the changes in the strengths of the heat diffusion members 301, 303, and 305 and shapes of natural vibration modes according to a first example (the case of FIG. 3A), a second example (the case of FIG. 3B), and a third example (the case of FIG. 3C) are illustrated. For example, it may be seen that the strengths of the heat diffusion members 301, 303, and 305 increase significantly in the order of the first example, the second example, and the third example, and it indicates that the natural vibration modes correspond to the first mode, second mode, and third mode, respectively. According to various embodiments, the locations, the shapes, the directions, and/or the number of the recesses may be determined while aiming to improve, among the natural vibration modes of the heat diffusion members 301, 303, and 305, the first mode, the second mode, and the third mode, which have a large influence on the deformation. For example, improving the bending characteristics of the heat diffusion members 301, 303, and 305 in the long lengthwise direction (e.g., the long axis direction) of the heat diffusion members 301, 303, 305, and 305 may be most effective in increasing the strengths of the heat diffusion members 301, 303, and 305. For example, when a recess is formed along the long lengthwise direction of the heat diffusion members 301, 303, and 305, the effect of increasing the strengths through the recess may be highest.

According to an embodiment, by forming at least one recess in the heat diffusion members 301, 303, and 305, the strengths of the heat diffusion members 301, 303, and 305 may be increased, and a possibility of deformation of and damage to the heat diffusion members 301, 303, and 305 from an external impact (e.g., falling of the electronic device or collision with an external object) may be decreased.

According to various embodiments, the shapes, the locations, the directions, and/or the number of the recesses that are formed in the heat diffusion members 301, 303, and 305 are not limited to the illustrations of FIGS. 3A to 3C.

FIG. 4 is a view illustrating a change in strength of the heat diffusion member of the electronic device according to an embodiment.

For example, reference numeral 410 denotes a first heat diffusion member 410 that does not include a recess 435, and reference numeral 420 denotes the strength of the first heat diffusion member 410 against an external impact. Reference numeral 430 denotes the second heat diffusion member 430 (e.g., the heat diffusion member 301 in FIG. 3A) including the recess 435, and reference numeral 440 denotes a strength of the second heat diffusion member 430 against an external impact. For example, the second heat diffusion member 430 may disperse the external impact through the recess 435, and thus, an amount of an external impact 445 that is applied to the second heat diffusion member 430 may be of a smaller scope and a lower strength compared to the amount of an external impact 425 that is applied to the first heat diffusion member 410.

For example, the first heat diffusion member 410 may not include the recess 435 that extends in the long lengthwise direction at a center thereof. In this case, because a strength (e.g., a stiffness) of the first heat diffusion member 410 is relatively small, there may be a high possibility of deformation and/or damage due to the impact applied to the first heat diffusion member 410.

For example, the second heat diffusion member 430 may include the recess 435 that extends in the long lengthwise direction at a center thereof. In this case, the strength of the second heat diffusion member 430 may be increased due to the recess 435. For example, when a relatively same external impact is applied, the second heat diffusion member 430 may be less likely to be deformed and/or a degree of damage may be decreased.

For example, as illustrated in FIG. 4, the first heat diffusion member 410 and the second heat diffusion member 430 may have the same shape and the same thickness, and when an external impact of the same intensity is applied, the stiffness of the first heat diffusion member 410 and the second heat diffusion member 430 may vary significantly. For example, as the recess 435 is formed, the stiffness of the second heat diffusion member 430 may increase greater than the stiffness of the first heat diffusion member 410, and a resistant force against the external impact (e.g., a yield stress) may increase significantly.

According to an embodiment, FIG. 4 illustrates only that the heat diffusion member (e.g., the second heat diffusion member 430) includes one recess 435 in the long lengthwise direction, but when the recesses 435 are formed in the respective directions, the strength of the heat diffusion member against an external impact in the corresponding directions may be increased.

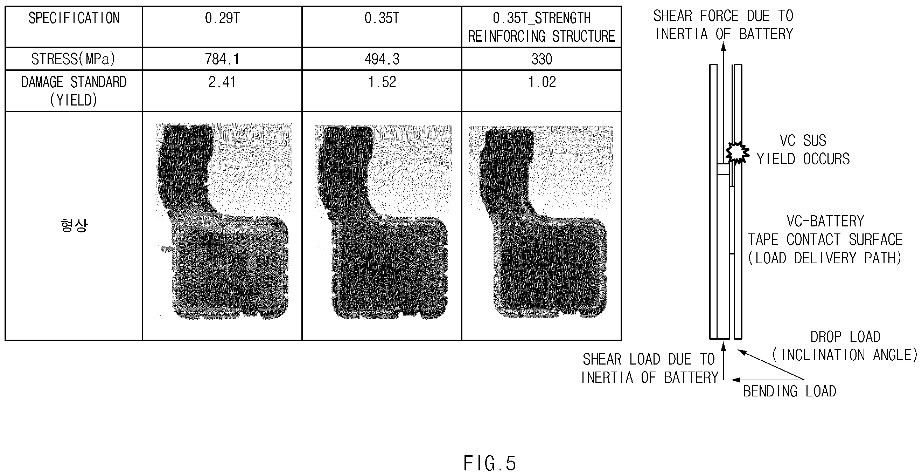

FIG. 5 illustrates the results of simulation of the damage degree due to a drop impact of the heat diffusion member of the electronic device according to an embodiment. For example, FIG. 5 illustrates the results of performance of a half sine wave stress simulation (using JEDEC H drop conditions) for a drop load of a JEDEC standard to change the specifications (e.g., a thickness) of a heat diffusion member (hereinafter referred to as "a vapor chamber (VC)") (e.g., the heat diffusion member 110 of FIG. 1, the heat diffusion member 210 of FIG. 2, the heat diffusion members 301, 303, and 305 of FIG. 3, the heat diffusion member 430 of FIG. 4, or the heat diffusion member 820 of FIG. 8) of the same shape or to check a degree of damage when a strength reinforcement structure (e.g., a recess) is applied.

For example, it may be identified that the stress decreases in the order of the first VC, the second VC, and the third VC, and the damage criterion (the yield) decreases when a standard drop simulation is performed at a specified height (e.g., 150 cm) for the first VC with a 0.29T specification, the second VC with a 0.35T specification, and the third VC with a strength reinforcement structure with a 0.35T specification. For example, as illustrated in the table of FIG. 5, it may be identified that a degree of deformation (e.g., a brightly indicated area) is severe in the order of the first VC, the second VC, and the third VC.

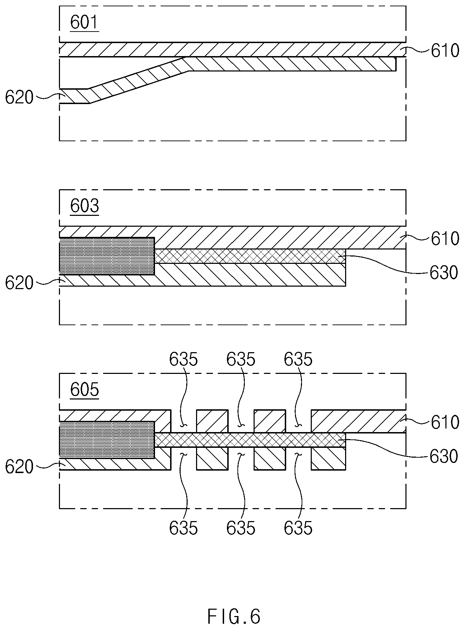

According to an embodiment, when an electronic device (e.g., a terminal) including a VC (e.g., the electronic device 901 in FIG. 9) falls, a shear force (a shear load) due to the inertial of the battery is generated and a plastic deformation may occur around a welded part of the VC. For example, a load may be delivered to a contact surface between the VC and the battery, a yield stress may occur in the VC, and a deformation and a damage may occur in a joining area of the VC. In FIG. 6 below, a flange structure for preventing deformation of the VC will be described in more detail.

FIG. 6 is a view illustrating the flange structure of the heat diffusion member according to various embodiments. For example, FIG. 6 illustrates a structure (hereinafter, referred to as "a flange structure") of a specific area of a periphery the heat diffusion member (e.g., the heat diffusion member 110 of FIG. 1, the heat diffusion member 210 of FIG. 2, the heat diffusion member 301, 303, and 305 of FIG. 3, the heat diffusion member 430 of FIG. 4, or the heat diffusion member 820 of FIG. 8).

According to an embodiment, a first heat diffusion member 601 may include a first plate 610 and a second plate 620. According to an embodiment, the first plate 610 and the second plate 620 may be joined to each other at a periphery of the first heat diffusion member 601 to form an external appearance of the first heat diffusion member 601. For example, the flange structure of the first heat diffusion member 601 may greatly affect the strength of the first heat diffusion member 601. For example, the first heat diffusion member 601 may be fixed to a support member in the interior of the electronic device through taping or laser welding. When using laser welding, the flange structure may have a relatively greater influence on the strength of the first heat diffusion member 601.

According to an embodiment, a second heat diffusion member 603 represents a case, in which a thickness of the flange structure is increased compared to the first heat diffusion member 601. For example, a thickness t2 of the flange structure of the second heat diffusion member 603 may be relatively thicker than a thickness t1 of the flange structure of the first heat diffusion member 601. For example, when the thickness of the first plate 610 and/or the second plate 620 that defines the flange structure is increased, the strength of the second heat diffusion member 603 may be increased. According to an embodiment, the thickness of the first plate 610 and/or the second plate 620 joined to each other in a designated area of a periphery of the second heat diffusion member 603 may be formed to be larger than a thickness of an outside of the designated area. According to an embodiment, a third plate 630 having a designated thickness may be joined between the first plate 610 and the second plate 620. For example, by additionally joining the third plate 630, the thickness of the flange structure of the second heat diffusion member 603 may be increased, and an effect of easily designing various welding surfaces (welding areas and/or shapes) may be achieved. For example, as the flange structure becomes thicker, a strength (e.g., stiffness) of the second heat diffusion member 603 may be increased.

According to an embodiment, at least one recess 635 (and/or a slit) may be formed in the first plate 610 and/or the second plate 620 of the flange structure of a third heat diffusion member 605. For example, when a recess 635 is formed in the flange structure, a secondary moment of inertia structurally increases due to the recess 635, and the strength of the heat diffusion member may increase. For example, it is illustrated that the third heat diffusion member 605 has a plurality of recesses 635 that are formed at an upper portion (the first plate 610) and a lower portion (the second plate 620) of the flange structure of the second heat diffusion member 603, but the embodiment of the present disclosure is not limited thereto. For example, the shapes, the locations, and/or the number of recesses 635 in the flange structure may vary, and the recesses 635 may be formed in various flange structures, including the flange structure of the first heat diffusion member 601. For example, the recess 635 may be formed in any one of the first plate 610 or the second plate 620, and the size, the shape, and/or the depth of the recess 635 may be formed differently. For example, the depth of the recess 635 may be the same as or smaller than the thicknesses of the first plate 610 and the second plate 620.

According to various embodiments, the shape of the flange structure and the shapes and the number of recesses are not limited to the illustration of FIG. 6, and the shape of the flange structure, a method of adjusting the thickness, and/or the structures or the number of recesses may be changed.

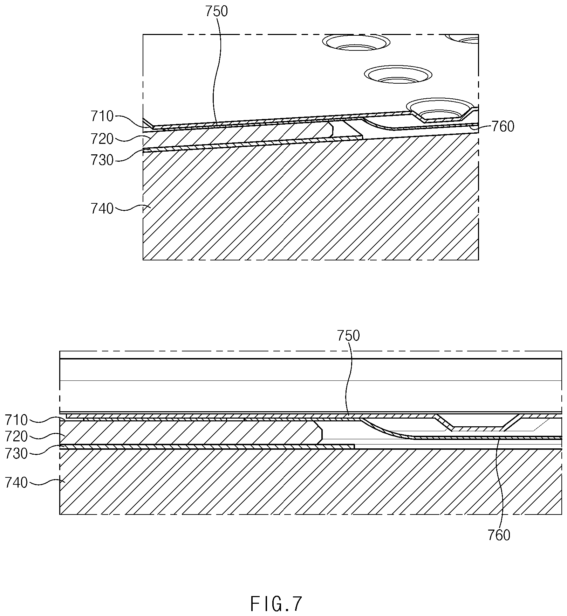

FIG. 7 is a view illustrating a structure of the heat diffusion member according to an embodiment. For example, FIG. 7 illustrates a flange structure of a heat diffusion member (e.g., the heat diffusion member **110** of FIG. **1****,** the heat diffusion member 210 of FIG. 2, the heat diffusion member 301; 303; and 305 of FIGS. 3A to 3C, the heat diffusion member 430 of FIG. 4, the heat diffusion member 601, 603, and 605 of FIG. 6, or the heat diffusion member 820 of FIG. 8) disposed in an interior of an electronic device (e.g., the electronic device 100 of FIG. 1, the electronic device 200 of FIG. 2, an electronic device 800 of FIG. 8, or the electronic device 901 of FIG. 9) according to an embodiment.

According to an embodiment, a periphery (e.g., the flange structure) of the heat diffusion member (e.g., the vapor chamber) may be disposed in the area, in which a battery 740 (e.g., a battery 989 in FIG. 9) of the interior of the electronic device is disposed. For example, a support structure 720 may be disposed on an upper side of the battery 740. For example, the support structure 720 may be joined to the battery 740 through a bonding tape 730. For example, a display 705 of the electronic device may be disposed at an upper portion of the support structure 720. According to an embodiment, the support structure 720 may be formed to support and fix the heat diffusion member. According to an embodiment, the support structure 720 may be joined to at least a portion of the heat diffusion member through a bonding tape 710 or laser welding.

According to an embodiment, the heat diffusion member may include a first plate 750 and a second plate 760. For example, the first plate 750 and the second plate 760 may be joined in a designated area of a periphery of the heat diffusion member to define a flange structure (e.g., 601, 603, and 605 in FIG. 6) of the heat diffusion member. According to an embodiment, the flange structure of the heat diffusion member may be attached to at least a portion of one surface of an upper structure and/or one surface of a lower structure. For example, the flange structure of the heat diffusion member may be attached to at least a portion of one surface that is an opposite surface (e.g., the display 705) to the battery 740. As another example, the flange structure of the heat diffusion member may be attached to at least a portion of one surface of the battery 740. For example, a space may be formed between the first plate 750 and the second plate 760 in a central area (other than the designated area) of the heat diffusion member, and a structure for diffusing heat may be formed.

According to an embodiment, the first plate 750 and the second plate 760 may have a larger thickness in the designated area (hereinafter, referred to as the "flange structure" of the heat diffusion member) of the periphery of the heat diffusion member than in an area other than the designated area. For example, the plate portion that defines the flange structure of the heat diffusion member may be formed to be thicker than other portions. For example, by joining the third plate between the first plate 750 and the second plate 760, the portion that defines the flange structure of the heat diffusion member may be formed to have a larger thickness than the other portions. According to an embodiment, the flange structure of the heat diffusion member may include at least one recess. For example, due to a flange structure including the recess, the secondary moment of inertia of the flange structure may be increased, and the strength of the heat diffusion member may be increased. For example, an additional plate including the recess may be joined to an outside of the first plate 750 and/or the second plate 760 so that a flange structure including a recess may be formed while the thickness of the flange structure is increased.

FIG. 8 is a view illustrating a heat diffusion member that is disposed in an electronic device, according to an embodiment.

According to an embodiment, the electronic device 800 (e.g., the electronic device 100 of FIG. **1****,** the electronic device 200 of FIG. 2, or the electronic device 901 of FIG. 9) may include a heat diffusion member 820 (e.g., the heat diffusion member 110 of FIG. **1****,** the heat diffusion member 210 of FIG. 2, the heat diffusion member 301, 303, and 305 of FIG. 3, the heat diffusion member 430 of FIG. 4, or the heat diffusion member 601, 603, and 605 of FIG. 6). According to an embodiment, the heat diffusion member 820 may diffuse heat generated from a first component (e.g., the processor) of an interior of the electronic device 800 to an area, in which a second component (e.g., the battery) is disposed. For example, the heat diffusion member 820 may diffuse high temperature heat generated from the first component (e.g., the processor) to lower a temperature of the first component (e.g., the processor), and prevent the first component (e.g., the processor) from malfunctioning, being damaged, and/or being damaged due to high temperature heat. For example, the heat diffusion member 820 may decrease the heat of the first component (e.g., the processor) that generates high temperature heat.

According to an embodiment, the heat diffusion member 820 may include at least one recess 825 and 827. According to an embodiment, the heat diffusion member 820 may include a first recess 825 that is formed along a central portion of the heat diffusion member 820. For example, the first recess 825 may be disposed along a long lengthwise direction of the heat diffusion member 820. For example, the first recess 825 may be formed in a line shape corresponding to the overall shape of the heat diffusion member 820. According to an embodiment, the heat diffusion member 820 may include a plurality of second recesses 827 having a length and a width that are smaller than those of the first recess 825, on the left and right sides of the first recess 825.

According to an embodiment, Because the heat diffusion member 820 includes at least one recess 825 and 827, the heat diffusion member 820 has an increased strength against an external impact (e.g., falling of the electronic device 800 and/or collision with an external object) and a degree of deformation or damage due to the external impact may be decreased.

According to various embodiments, the locations, the directions, the shapes, and/or the number of recesses included in the heat diffusion member 820 is not limited to the illustration of FIG. 8.

When the area of the heat diffusion member included in the electronic device increases, a low order mode in a natural frequency mode may increase as a proportion of the heat diffusion member in the electronic device increases. In this case, when the electronic device drops, a magnitude of a force that is applied to the heat diffusion member may increase, and a possibility of the heat diffusion member being deformed or damaged by an external impact may increase. Various embodiments of the present disclosure provide a heat diffusion member that may increase a strength of a heat diffusion member and decrease deformation and damage against an external impact, and an electronic device including the heat diffusion member.

According to an embodiment, an electronic device (e.g., the electronic device 100 of FIG. 1, the electronic device 200 of FIG. 2, the electronic device 800 of FIG. 8, or the electronic device 901 of FIG. 9) may include a housing, a first electronic component disposed in a first area of an interior of the housing, a second electronic component disposed in a second area being different from the first area of the interior of the housing, and a heat diffusion member (e.g., the heat diffusion member 110 of FIG. 1, the heat diffusion member 210 of FIG. 2, the heat diffusion member 301, 303, and 305 of FIGS. 3A to 3C, the heat diffusion member 430 of FIG. 4, the heat diffusion member 601, 603, and 605 of FIG. 6, or the heat diffusion member 820 of FIG. 8) disposed in a heat dissipation area formed from the first area to the second area, and including a first part (e.g., the first part of FIG. 3A) corresponding to the first area, a second part (e.g., the second part 320 of FIG. 3A) corresponding to the second area, and a connecting part (the connecting part 320 of FIG. 3A) connecting the first part and the second part. According to an embodiment, the heat diffusion member may include at least one recess (slit) (e.g., the recess 341, 343, 350, and 360 of FIGS. 3A to 3C), the recess 435 of FIG. 4, or the recess 825 and 827 of FIG. 8).

According to an embodiment, the heat diffusion member of the electronic device includes at least one recess, thereby increasing a strength against an external impact and dispersing the external impact through the recess to prevent or decrease deformation and/or damage due to the external impact.

According to an embodiment, the heat diffusion member may include a vapor chamber.

According to an embodiment, the at least one recess may include a first recess extending from at least a portion of the first part of the heat diffusion member to at least a portion of the second part via the connecting part.

According to an embodiment, the first recess may be disposed along a center line of the heat diffusion member, which extends from the at least a portion of the first part to the at least a portion of the second part.

According to an embodiment, the at least one recess may include at least one second recess formed in a second direction being different from a first direction expanded from the first part to the second part in the connecting part of the heat diffusion member.

According to an embodiment, the at least one recess may include a third recess formed to have a specific angle with the first recess in the second part of the heat diffusion member.

According to an embodiment, the at least one third recess may include a recess intersecting the first recess at a right angle.

According to an embodiment, the heat diffusion member may include a first plate and a second plate, and the first plate and the second plate may be joined to each other in a specific area of a periphery of the heat diffusion member, and the first plate and the second plate may be formed to have a thickness being greater in the joined area than in an area other than the joined area.

According to an embodiment, the heat diffusion member may further include a third plate disposed between the first plate and the second plate to join the first plate and the second plate in the joined area.

According to an embodiment, at least one of the first plate or the second plate may include at least one recess structure formed in a direction being parallel to an edge of the heat diffusion member in the joined area.

According to an embodiment, the heat diffusion member may include a fourth plate joined to one of an opposite surface to a surface of the first plate, which is joined to the second plate, or an opposite surface to a surface of the second plate, which is joined to the first plate, and including at least one recess structure.

According to an embodiment, the second area may be greater than the first area.

According to an embodiment, the first electronic component may include a processor, and the second electronic component includes a battery.

According to an embodiment, the heat diffusion member may diffuse heat generated in the first electronic component to the second area.

According to an embodiment, a heat diffusion member may include a first part, a second part configured to diffuse heat from the first part, a connecting part connecting the first part and the second part, and a first recess extending from at least a portion of the first part to at least a portion of the second part via the connecting part.

According to an embodiment, the first recess may be disposed along a center line of the heat diffusion member, which extends from the at least a portion of the first part to the at least a portion of the second part.

According to an embodiment, the heat diffusion member may further include at least one second recess formed in the connecting part of the heat diffusion member in a second direction being different from a first direction expanded from the first part to the second part.

According to an embodiment, the heat diffusion member may further include at least one third recess formed to have a specific angle with the first recess in the second part of the heat diffusion member.

According to an embodiment, the heat diffusion member may include a first plate, and a second plate, and the first plate and the second plate may be joined to each other in a specific first area of a periphery of the heat diffusion member, and the first plate and the second plate may be formed to have a thickness being greater in the first area than in a second area being different from the first area.

According to an embodiment, at least one of the first plate or the second plate may include at least one recess structure formed in a direction being parallel to an edge of the heat diffusion member in the joined area.

FIG. 9 is a block diagram illustrating an electronic device 901 in a network environment 900 according to various embodiments. Referring to FIG. 9, the electronic device 901 in the network environment 900 may communicate with an electronic device 902 via a first network 998 (e.g., a short-range wireless communication network), or at least one of an electronic device 904 or a server 908 via a second network 999 (e.g., a long-range wireless communication network). According to an embodiment, the electronic device 901 may communicate with the electronic device 904 via the server 908. According to an embodiment, the electronic device 901 may include a processor 920, a memory 930, an input module 950, a sound output module 955, a display module 960, an audio module 970, a sensor module 976, an interface 977, a connecting terminal 978, a haptic module 979, a camera module 980, a power management module 988, a battery 989, a communication module 990, a subscriber identification module 996, or an antenna module 997. In some embodiments, at least one (e.g., the connecting terminal 978) of the components may be omitted from the electronic device 901, or one or more other components may be added in the electronic device 901. In some embodiments, some (e.g., the sensor module 976, the camera module 980, or the antenna module 997) of the components may be implemented as single component (the display module 960).

The processor 920 may execute, for example, software (e.g., a program 940) to control at least one other component (e.g., a hardware or software component) of the electronic device 901 coupled with the processor 920, and may perform various data processing or computation. According to one embodiment, as at least part of the data processing or computation, the processor 920 may store a command or data received from another component (e.g., the sensor module 976 or the communication module 990) in a volatile memory 932, process the command or the data stored in the volatile memory 932, and store resulting data in a non-volatile memory 934. According to an embodiment, the processor 920 may include a main processor 921 (e.g., a central processing unit (CPU) or an application processor (AP)), and an auxiliary processor 923 (e.g., a graphics processing unit (GPU), a neural processing unit (NPU), an image signal processor (ISP), a sensor hub processor, or a communication processor (CP)) that is operable independently from, or in conjunction with, the main processor 921. When the electronic device 901 includes the main processor 921 and the auxiliary processor, the auxiliary processor 923 may be adapted to consume less power than the main processor 921, or to be specific to a specified function. The auxiliary processor 923 may be implemented as separate from, or as part of the main processor 921.

The auxiliary processor 923 may control at least some of functions or states related to at least one component (e.g., the display module 960, the sensor module 976, or the communication module 990) among the components of the electronic device 901, instead of the main processor 921 while the main processor 921 is in an inactive (e.g., sleep) state, or together with the main processor 921 while the main processor 921 is in an active state (e.g., executing an application). According to an embodiment, the auxiliary processor 923 (e.g., an image signal processor or a communication processor) may be implemented as part of another component (e.g., the camera module 980 or the communication module 990) functionally related to the auxiliary processor 923. According to an embodiment, the auxiliary processor 923 (e.g., a neural network processing device) may include a hardware structure specified for processing an artificial intelligence (AI) model. The AI model may be generated through machine learning. The learning may be performed by the electronic device 901 performing the AI model, and may be performed through an additional server (e.g., the server 908). A learning algorithm may include, for example, a supervised learning algorithm, an unsupervised learning algorithm, a semisupervised learning algorithm, or a reinforcement learning algorithm, but the disclosure is not limited thereto. The AI model may include a plurality of artificial neural network (ANN) layers. The ANN may include a deep neural network (DNN), a convolutional neural network (CNN), a recurrent neural network (RNN), a restricted boltzman machine (RBM), a deep belief network (DBN), a bidirectional recurrent deep neural network (BRDNN), a deep Q-networks or the combination of the above networks, but the disclosure is not limited thereto. The AI model may additionally or alternatively include a software structure, in addition to a hardware structure.

The memory 930 may store various data used by at least one component (e.g., the processor 920 or the sensor module 976) of the electronic device 901. The various data may include, for example, software (e.g., the program 940) and input data or output data for a command related thereto. The memory 930 may include the volatile memory 932 or the non-volatile memory 934.

The program 940 may be stored in the memory 930 as software, and may include, for example, an operating system (OS) 942, middleware 944, or an application 946.

The input module 950 may receive a command or data to be used by other component (e.g., the processor 920) of the electronic device 901, from the outside (e.g., a user) of the electronic device 901. The input module 950 may include, for example, a microphone, a mouse, a keyboard, a key (e.g., a button), or a digital pen (e.g., a stylus pen).

The sound output module 955 may output sound signals to the outside of the electronic device 901. The sound output module 955 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display module 960 may visually provide information to the outside (e.g., a user) of the electronic device 901. The display module 960 may include, for example, a display, a hologram device, or a projector and control circuitry to control a corresponding one of the display, hologram device, and projector. According to an embodiment, the display module 960 may include touch sensor adapted to detect a touch, or a pressure sensor adapted to measure the intensity of force incurred by the touch.

The audio module 970 may convert a sound into an electrical signal and vice versa. According to an embodiment, the audio module 970 may obtain the sound via the input module 950, or output the sound via the sound output module 955 or an external electronic device (e.g., the electronic device 902) (e.g., speaker of headphone) directly (e.g., wiredly) or wirelessly coupled with the electronic device 901.

The sensor module 976 may detect an operational state (e.g., power or temperature) of the electronic device 901 or an environmental state (e.g., a state of a user) external to the electronic device 901, and then generate an electrical signal or data value corresponding to the detected state. According to an embodiment, the sensor module 976 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 977 may support one or more specified protocols to be used for the electronic device 901 to be coupled with the external electronic device (e.g., the electronic device 902) directly (e.g., by wire) or wirelessly. According to an embodiment, the interface 977 may include, for example, a high definition multimedia interface (HDMI), a universal serial bus (USB) interface, a secure digital (SD) card interface, or an audio interface.

A connecting terminal 978 may include a connector via which the electronic device 901 may be physically connected with the external electronic device (e.g., the electronic device 902). According to an embodiment, the connecting terminal 978 may include, for example, a HDMI connector, a USB connector, a SD card connector, or an audio connector (e.g., a headphone connector).

The haptic module 979 may convert an electrical signal into a mechanical stimulus (e.g., a vibration or a movement) or electrical stimulus which may be recognized by a user via his tactile sensation or kinesthetic sensation. According to an embodiment, the haptic module 979 may include, for example, a motor, a piezoelectric element, or an electric stimulator.

The camera module 980 may capture a still image or moving images. According to an embodiment, the camera module 980 may include one or more lenses, image sensors, image signal processors, or flashes.

The power management module 988 may manage power supplied to the electronic device 901. According to one embodiment, the power management module 988 may be implemented as at least part of, for example, a power management integrated circuit (PMIC).

The battery 989 may supply power to at least one component of the electronic device 901. According to an embodiment, the battery 989 may include, for example, a primary cell which is not rechargeable, a secondary cell which is rechargeable, or a fuel cell.

The communication module 990 may support establishing a direct (e.g., wired) communication channel or a wireless communication channel between the electronic device 901 and the external electronic device (e.g., the electronic device 902, the electronic device 904, or the server 908) and performing communication via the established communication channel. The communication module 990 may include one or more communication processors that are operable independently from the processor 920 (e.g., the application processor (AP)) and supports a direct (e.g., wired) communication or a wireless communication. According to an embodiment, the communication module 990 may include a wireless communication module 992 (e.g., a cellular communication module, a short-range wireless communication module, or a global navigation satellite system (GNSS) communication module) or a wired communication module 994 (e.g., a local area network (LAN) communication module or a power line communication (PLC) module). The communication module among these communication modules may communicate with the external electronic device 904 via the first network 998 (e.g., a short-range communication network, such as Bluetooth^{™}, wireless-fidelity (WiFi) direct, or infrared data association (IrDA)) or the second network 999 (e.g., a long-range communication network, such as a legacy cellular network, 5G network, next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 992 may identify or authenticate the electronic device 901 in a communication network, such as the first network 998 or the second network 999, using subscriber information (e.g., international mobile subscriber identity (IMSI)) stored in the subscriber identification module 996.

The wireless communication module 992 may support a 5G network and a next-generation communication technology, for example, a new radio (NR) access technology after a 4G network. The NR access technology may support high-speed transmission for high capacity data (enhanced mobile broadband; eMBB), terminal power minimizing and multiple terminal access (massive machine type communication; mMTC), or ultra-reliable and low-latency communications (URLLC). The wireless communication module 992 may support a high-frequency band (e.g., mmWave band) to achieve, for example, a higher data rate. The wireless communication module 992 may support various technologies, for example, beamforming, massive multiple-input and multipleoutput (MIMO), Full-dimensional MIMO, an array antenna, analog beamforming, or a large-scale antenna, to secure performance in high frequency bands. The wireless communication module 992 may support various requirements defined in the electronic device 901, the external electronic device (e.g., the electronic device 904) or the network system (e.g., the second network 999). According to one embodiment, the wireless communication module 992 may support a peak data rate (e.g., 20Gbps or more) for eMBB realization, loss coverage (e.g., 164 dB or less) for mMTC realization, or U-plane latency (e.g., 0.5 ms or less, or the round trip of 1 ms or less in each of a downlink (DL) and an uplink (UL)) for URLCC realization.

The antenna module 997 may transmit or receive a signal or power to or from the outside (e.g., the external electronic device). According to an embodiment, the antenna module 997 may include an antenna including a radiating element composed of a conductive material or a conductive pattern formed in or on a substrate (e.g., PCB). According to an embodiment, the antenna module 997 may include a plurality of antennas (e.g., an array antenna). In such a case, at least one antenna appropriate for a communication scheme used in the communication network, such as the first network 998 or the second network 999, may be selected, for example, by the communication module 990 from the plurality of antennas. The signal or the power may then be transmitted or received between the communication module 990 and the external electronic device via the selected at least one antenna. According to an embodiment, another component (e.g., a radio frequency integrated circuit (RFIC)) other than the radiating element may be additionally formed as part of the antenna module 997.

According to various embodiments, the antenna module 997 may form an mmWave antenna module. According to an embodiment, the mmWave antenna module may include a printed circuit board, an RFIC disposed on a first surface (e.g., a bottom surface) of the printed circuit board, or disposed adjacent to the first surface to support the specific high frequency band (e.g., mmWave band), and a plurality of antennas (e.g., an array antenna) disposed on a second surface (e.g., a top surface or a side surface) of the printed circuit board or disposed adjacent to the second surface to transmit or receive a signal having the specified high frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 901 and the external electronic device 904 via the server 908 coupled with the second network 999. Each of the external electronic devices 902 or 104 may be a device of a same type as, or a different type, from the electronic device 901. According to an embodiment, all or some of operations to be executed at the electronic device 901 may be executed at one or more of the external electronic devices 902, 104, or 108. For example, when the electronic device 901 should perform a function or a service automatically, or in response to a request from a user or another device, the electronic device 901, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 901. The electronic device 901 may provide the outcome, with or without further processing of the outcome, as at least part of a reply to the request. To that end, a cloud computing, distributed computing, mobile edge computing (MEC), or client-server computing technology may be used, for example. The electronic device 901 may provide an ultra-latency service by using, for example, distributed computing or mobile edge computing. According to various embodiments, the external electronic device 904 may include the Internet of things (IoT). The server 908 may be an artificial server using machine learning and/or a neural network. According to an embodiment, the external electronic device 904 or the server 908 may be included in the second network 999. The electronic device 901 may be applied to an artificial intelligence service (e.g., a smart home, a smart city, a smart car, or healthcare service) based on the 5G communication technology and the IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 940) including one or more instructions that are stored in a storage medium (e.g., internal memory 936 or external memory 938) that is readable by a machine (e.g., the electronic device 901). For example, a processor (e.g., the processor 920) of the machine (e.g., the electronic device 901) may invoke at least one of the one or more instructions stored in the storage medium, and execute it. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities and some of multiple entities may be separately disposed on the other components. According to various embodiments, one or more of the above-described components may be omitted, or one or more other components may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a housing;
a first electronic component disposed in a first area of an interior of the housing;
a second electronic component disposed in a second area being different from the first area of the interior of the housing; and
a heat diffusion member (110; 210; 301; 303; 304) disposed in a heat dissipation area formed from the first area to the second area, and including a first part corresponding to the first area, a second part corresponding to the second area, and a connecting part connecting the first part and the second part,
wherein the heat diffusion member includes at least one recess.

2. The electronic device of claim 1, wherein the heat diffusion member (110; 210; 301; 303; 304) includes a vapor chamber.

3. The electronic device of claim 1, wherein the at least one recess includes:
a first recess (341; 343) extending from at least a portion of the first part of the heat diffusion member to at least a portion of the second part via the connecting part.

4. The electronic device of claim 3, wherein the first recess is disposed along a center line of the heat diffusion member, which extends from the at least a portion of the first part to the at least a portion of the second part.

5. The electronic device of claim 1, wherein the at least one recess includes:
at least one second recess (350) formed in a second direction being different from a first direction expanded from the first part to the second part in the connecting part of the heat diffusion member.

6. The electronic device of claim 3, wherein the at least one recess includes:
at least one third recess (360) formed to have a specific angle with the first recess in the second part of the heat diffusion member.

7. The electronic device of claim 6, wherein the at least one third recess includes:
a recess intersecting the first recess at a right angle.

8. The electronic device of claim 1, wherein the heat diffusion member includes a first plate (610) and a second plate (620), and
wherein the first plate and the second plate are joined to each other in a specific area of a periphery of the heat diffusion member, and the first plate and the second plate are formed to have a thickness being greater in the specific area of the periphery than in an area other than the specific area of the periphery.

9. The electronic device of claim 8, wherein the heat diffusion member further includes a third plate disposed between the first plate and the second plate to join the first plate and the second plate in the specific area of the periphery.

10. The electronic device of claim 8, wherein at least one of the first plate or the second plate includes at least one recess structure formed in a direction being parallel to an edge of the heat diffusion member in the specific area of the periphery.

11. The electronic device of claim 8, wherein the heat diffusion member includes a fourth plate joined to one of an opposite surface to a surface of the first plate, which is joined to the second plate, or an opposite surface to a surface of the second plate, which is joined to the first plate, and including at least one recess structure.

12. The electronic device of claim 1, wherein the second area is greater than the first area.

13. The electronic device of claim 1, wherein the first electronic component includes a processor, and the second electronic component includes a battery.

14. The electronic device of claim 1, wherein the heat diffusion member diffuses heat generated in the first electronic component to the second area.

15. A heat diffusion member comprising:
a first part (310);
a second part (320) configured to diffuse heat from the first part;
a connecting part (330) connecting the first part and the second part; and
a first recess (341; 343) extending from at least a portion of the first part to at least a portion of the second part via the connecting part.
